# EUROPÄISCHE PATENTSCHRIFT

(11) **EP 2 056 460 B1**
(45) Veröffentlichungstag und Bekanntmachung des Hinweises auf die Patenterteilung: **19.12.2012**
(21) Anmeldenummer: 08019156.2
(22) Anmeldetag: 31.10.2008
(51) Int. Cl.: H03F 1/30, H03M 1/10, H03M 1/06, H03M 1/12

(54) **Verfahren und Anordnung eines Messverstärkers zur Korrektur von Eingangssignalen**
Method and arrangement for a measurement amplifier to correct input signals
Procédé et agencement d'un renforceur de mesure destiné à la correction de signaux d'entrée

(30) Priorität: 02.11.2007 DE 102007052440
(43) Veröffentlichungstag der Anmeldung: 06.05.2009
(73) Patentinhaber: Hottinger Baldwin Messtechnik GmbH, 64293 Darmstadt (DE)
(72) Erfinder: Schneider, Jochen, Dr., 64372 Ober-Ramstadt (DE); Kunkel, Ulrich, 64807 Dieburg (DE)
(74) Vertreter: Staudte, Ralph

(56) Entgegenhaltungen:
- WO-A-2006/109013
- US-A- 5 311 452
- US-A1- 2007 109 159
- US-B1- 6 414 612

## Beschreibung

Die Erfindung betrifft ein Verfahren und eine Anordnung eines Messverstärkers zur Korrektur von Eingangssignalen nach dem Oberbegriff des Anspruchs 1 bzw. nach Anspruch 10.

Mit einem Messverstärker werden elektrische Eingangssignale empfangen, gefiltert, linearisiert, verstärkt und normiert, sodass diese als Messwerte weiter verarbeitbar sind. Die in den Messverstärkern angeordneten Messverstärkerschaltungen bestehen in der Regel aus einer Vielzahl von Bauelementen, wobei jedes der einzelnen Bauelemente eine eigene Toleranz aufweist. Durch die Toleranzen wird die Genauigkeit der Messung des Eingangssignals bestimmt. Das durch Temperatur und Alterung bedingte Driftverhalten der einzelnen Bauelemente ist nur begrenzt kontrollierbar.

Um das Driftverhalten zu kompensieren werden zum Beispiel sogenannte Dual-Slope-Wandler verwendet. Hierbei wird in bestimmten Zeitintervallen das eigentliche Messsignal gemessen. Zwischen den bestimmten Zeitintervallen wird eine Vergleichsmessung durchgeführt. Alternativ ist vorgesehen, dass der Messverstärkereingang zwischen einem Messsignal und einem internen Kalibriersignal oder internen Nullsignal umgeschaltet wird, um die Drifteinflüsse der Verstärkungsschaltung zu ermitteln und bei der eigentlichen Messung das Eingangssignal zu korrigieren. Beide vorbeschriebenen Verfahren weisen den Nachteil auf, dass die eigentliche Messung des Eingangssignals unterbrochen werden muss und nicht mehr kontinuierlich erfolgen kann. Dieser Nachteil macht sich insbesondere bemerkbar, wenn integrierte Analog-Digital-Wandlerverfahren mit nachgeschalteten Digitalfiltern verwendet werden, die grundsätzlich eine kontinuierliche Messung des Eingangssignals voraussetzen. Dies ist insbesondere auch bei Messwerten von Nachteil, die für Regelungsaufgaben verwendet werden sollen, da dadurch eine ununterbrochene Regelung nicht möglich ist.

Die DE 36 42 771 A1 beschreibt ein Verfahren zur Messung einer Messgröße eines Messobjekts, das mit einem Messwertaufnehmer oder Ähnlichem verbunden ist, der ein der Messgröße entsprechendes Messsignal bereitstellt. Um Messungenauigkeiten wie Messschaltungstoleranzen und unvermeidliche Störgrößen wie Offseteinflüsse, Driften und Ähnliches zu vermeiden, wird an das Messobjekt eine Hilfsgröße angelegt. Aufgrund der Hilfsgröße und des Messsignals kann die Messgröße bestimmt werden. Die Hilfsgröße weist hierzu den zeitlichen Verlauf eines pseudo-zufälligen Rauschsignals auf. Das Rauschsignal wird aufgrund eines Steuersignals von einem Prozessor abgegeben und nach jedem Messintervall für eine bestimmte Zeitspanne unterbrochen. Das Messsignal wird über einen Analog-Digital-Wandler dem Prozessor zugeführt, der aus dem Messsignal, dem Steuersignal und dem Rauschsignal das eigentliche Messsignal herausfiltert. Auch bei diesem Messverfahren ist nachteilig, dass eine kontinuierliche Messung der Messgröße nicht möglich ist.

Es ist die Aufgabe der Erfindung, ein Verfahren und eine Anordnung eines Messverstärkers zur Korrektur von Eingangssignalen anzugeben, bei denen eine Korrektur von kontinuierlich gemessenen Messwerten für ein Eingangssignal ermöglicht wird.

Diese Aufgabe wird erfindungsgemäß mit den Merkmalen des Anspruchs 1 bzw. des Anspruchs 10 gelöst.

Die Anordnung eines Messverstärkers zur Korrektur von Eingangssignalen weist eine erste analoge Verstärkerschaltung auf, die kontinuierlich ein Eingangssignal misst und in entsprechende Messwerte umwandelt. Eine zweite analoge Verstärkerschaltung ist wahlweise schaltbar auf das Eingangssignal, ein Referenzsignal oder ein Nullsignal, d.h. dass die zweite analoge Verstärkerschaltung wahlweise das Eingangssignal, das Referenzsignal oder Nullsignal misst. Zur Erzeugung des Referenzsignals oder des Nullsignals sind entsprechende Mittel vorgesehen. Jeder der beiden Verstärkerschaltungen ist ein Analog-Digital-Umsetzer nachgeschaltet. Mit den beiden Analog-Digital-Umsetzern ist wenigstens ein Mikroprozessor gekoppelt. Durch das wahlweise Schalten der zweiten Verstärkerschaltung an das Eingangssignal bzw. an das Referenzsignal bzw. an das Nullsignal ist ermöglicht, dass in regelmäßigen Abständen die jeweils aktuellen Driftfehler der zweiten Verstärkerschaltung bestimmt werden, was durch den Vergleich der Messung des Referenzsignals und des Nullsignals mit der zweiten Verstärkerschaltung ermöglicht ist. Durch Abweichungen in der Messung des Referenzsignals und des Nullsignals werden die Driftfehler der zweiten Verstärkerschaltung ermittelt. Die durch die zweite Verstärkerschaltung aufgenommenen Messwerte werden entsprechend korrigiert.

Im Messbetrieb der Anordnung werden die unkorrigierten Messwerte der ersten Verstärkerschaltung kontinuierlich mit den korrigierten Messwerten der zweiten Verstärkerschaltung verglichen. Der Mikroprozessor ermittelt aus dem Vergleich der unkorrigierten Messwerte der ersten Verstärkerschaltung und der korrigierten Messwerte der zweiten Verstärkerschaltung Korrekturwerte für die Messwerte der ersten Verstärkerschaltung. Für die Bestimmung der Korrekturwerte genügen einzelne nicht zusammenhängende Messwertpaare. Die Messwerte der ersten analogen Verstärkerschaltung werden dann aufgrund der ermittelten Korrekturwerte korrigiert. Dadurch wird erreicht, dass während einer kontinuierlichen Messung des Eingangssignals Korrekturwerte für die durch das Eingangssignal gegebenen Messwerte ermittelt werden können. Eine Unterbrechung der Messung des Eingangssignals zur Bestimmung der Korrekturwerte bzw. für die Messung von entsprechenden Referenzsignalen wird vermieden.

Zu beachten ist hierbei lediglich, dass die erste Verstärkerschaltung mit der zweiten Verstärkerschaltung baugleich vorgesehen ist, sodass die beiden Verstärkerschaltungen übereinstimmende Signallaufzeiten haben. Zudem ist Voraussetzung, dass der erste Analog-Digital-Umsetzer und der zweite Analog-Digital-Umsetzer ebenfalls baugleich sind, sodass die beiden Analog-Digital-Umsetzer parallel und ohne einen Zeitversatz arbeiten. Diese Voraussetzungen sind jedoch durch die Verwendung von gleichartigen Bauelementen einfach sicherzustellen. Überdies ist zu beachten, dass das Referenzsignal und das Nullsignal eine sehr geringe Drift mit der Zeit und bei wechselnder Temperatur aufweisen. Zur Bestimmung der absoluten Größe des Referenzsignals und des Nullsignals ist zum Beispiel ein externes Kalibriernormal vorgesehen.

In einer ersten vorteilhaften Ausgestaltung sind die beiden Verstärkerschaltungen jeweils als Brückenmessverstärker vorgesehen. Das Referenzsignal wird in diesem Fall durch einen Widerstandsteiler erzeugt.

In einer anderen vorteilhaften Ausgestaltung sind die beiden Vestärkerschaltungen jeweils als Spannungsverstärker vorgesehen, wobei dann das Referenzsignal durch eine Referenzspannungsquelle erzeugt wird.

Der Analog-Digital-Umsetzer ist vorteilhaft durch einen Stereo-Audio-Wandler gegeben.

Aus einzelnen Messwertpaaren können zwar Offsetkorrekturen bestimmt werden, jedoch ist die Bestimmung einer Verstärkungskorrektur nicht möglich. In einer bevorzugten Ausgestaltung ist deshalb vorgesehen, dass Messwertpaare bei verschiedenen anliegenden Signalpegeln ermittelt werden. Die Messverstärkerschaltungen haben aber nun keinen Einfluss auf den Pegel des Eingangssignals, dieser ist vielmehr durch die gegebene Messwertaufgabe und die entsprechend durchgeführte Messung gegeben. Hierzu ist ein geeigneter Algorithmus notwendig, der aus den Signalpegeln diejenigen Messwerte auswählt, die eine Bestimmung sowohl der Offsetfehler als auch der Verstärkungsfehler ermöglichen.

Die Driftfehler der Verstärkerschaltung sind zeitlich nicht konstant, sodass die für die Korrektur notwendige Aussagekraft der Messwerte von deren Alter abhängt, d.h. zu welchem Zeitpunkt der jeweilige Messwert aufgenommen worden ist. Dementsprechend ist zweckmäßig vorgesehen, dass die Messwerte mit einer Gewichtungsfunktion korreliert werden, die insbesondere das Alter der Messwerte berücksichtigt.

In einer weiteren bevorzugten Ausgestaltung werden die Differenzen der unkorrigierten Messwerte der ersten Verstärkerschaltung und der korrigierten Messwerte der zweiten Verstärkerschaltung ermittelt, indem eine Ausgleichsgerade mit dem kleinsten Fehlerquadrat berechnet wird. Aufgrund der Steigung der Ausgleichsgeraden wird dann die Korrektur der Verstärkung bestimmt. Der Nulldurchgang der Geraden bestimmt hingegen die Korrektur des Offsetfehlers.

Weitere Vorteile der Erfindung ergeben sich aus den abhängigen Ansprüchen und der nachfolgenden Beschreibung.

Nachfolgend wird die Erfindung anhand eines bevorzugten Ausführungsbeispiels unter Bezugnahme auf die anliegende Zeichnung näher erläutert.
- Fig. 1: zeigt ein bevorzugtes Ausführungsbeispiel einer erfindungsgemäßen Anordnung eines Messverstärkers zur Korrektur von Eingangssignalen.
- Fig. 2: zeigt ein Verfahren zur Bestimmung von Korrekturwerten für die Anordnung aus Fig. 1.

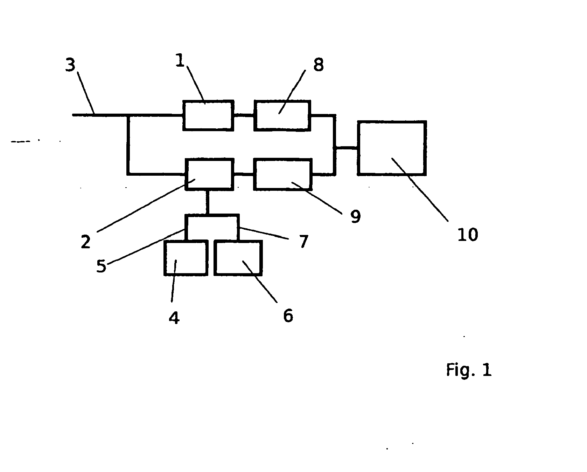

In Fig. 1 ist ein bevorzugtes Ausführungsbeispiel einer erfindungsgemäßen Anordnung eines Messverstärkers zur Korrektur von Eingangssignalen gezeigt, die eine erste analoge Verstärkerschaltung 1 und eine zweite analoge Verstärkerschaltung 2 umfasst. Die erste analoge Verstärkerschaltung 1 misst kontinuierlich ein Eingangssignal 3 und wandelt dieses in Messwerte um.

Mit der zweiten analogen Verstärkerschaltung 2 sind Mittel 4 zur Erzeugung eines Referenzsignals 5 und Mittel 6 zur Erzeugung eines Nullsignals 7 gekoppelt. Die zweite analoge Verstärkerschaltung 2 misst wahlweise das Eingangssignal 3, das Referenzsignal 5 und das Nullsignal 7. Die erste und die zweite Verstärkerschaltung 1 und 2 sind hierbei durch gleichartige Bauelemente gegeben, sodass die Verstärkerschaltungen 1 und 2 im Wesentlichen gleiche Signallaufzeiten aufweisen. Mit der ersten Verstärkerschaltung 1 ist ein erster Analog-Digital-Umsetzer 8 und mit der zweiten Verstärkerschaltung 2 ein zweiter Analog-Digital-Umsetzer 9 gekoppelt.

Mit den beiden Analog-Digital-Umsetzern 8 und 9 ist ein Mikroprozessor 10 verbunden.

Das erfindungsgemäße Verfahren zur Korrektur von Eingangssignalen funktioniert nun wie folgt:

Die erste Verstärkerschaltung 1 misst kontinuierlich das Eingangssignal 3 und wandelt das Eingangssignal kontinuierlich in entsprechende Messwerte um, die der erste Analog-Digital-Umsetzer 8 in für den Mikroprozessor 10 auswertbare digitale Signale umsetzt.

Die zweite Verstärkerschaltung 2 misst in einem ersten bestimmten Zeitabschnitt das Eingangssignal 3. In einem zweiten bestimmten Zeitabschnitt misst die zweite Verstärkerschaltung 2 dann das Referenzsignal 5 und das Nullsignal 7. Diese beiden Zeitabschnitte werden permanent wiederholt, sodass abwechselnd das Eingangssignal 3 und das Referenzsignal 5 bzw. das Nullsignal 7 von der zweiten Verstärkerschaltung 2 gemessen werden. Die zweite Verstärkerschaltung 2 wandelt sowohl das Eingangssignal 3, das Referenzsignal 5 als auch das Nullsignal 7 um und leitet diese an den zweiten Analog-Digital-Umsetzer 9 weiter. Der zweite Analog-Digital-Umsetzer 9 setzt die Messwerte der zweiten Verstärkerschaltung 2 in für den Mikroprozessor 10 verwertbare digitale Signale um. Dadurch ist in regelmäßigen Abständen die Drift der zweiten Verstärkerschaltung 2 bestimmbar. Der Mikroprozessor 10 korrigiert dementsprechend die Messwerte der zweiten Verstärkerschaltung 2.

Im Messbetrieb der Anordnung vergleicht der Mikroprozessor 10 dann die unkorrigierten Messwerte der ersten Verstärkerschaltung 1 mit den korrigierten Messwerten der zweiten Verstärkerschaltung 2. Aus dem Vergleich der Messwerte der ersten Verstärkerschaltung 1 mit den Messwerten der zweiten Verstärkerschaltung 2 bestimmt der Mikroprozessor 10 Korrekturwerte für den Offsetfehler und für die Korrektur der Verstärkungsfehler.

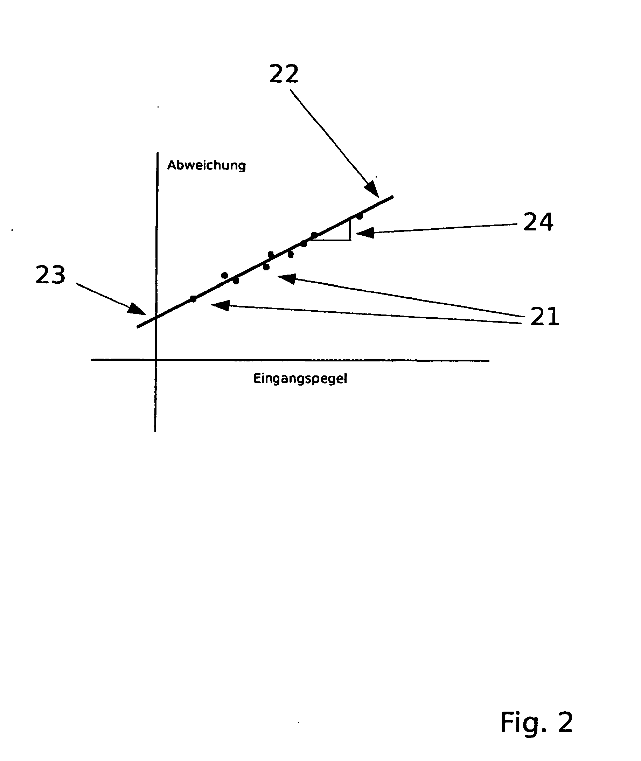

In Fig. 2 ist ein bevorzugtes Verfahren zur Bestimmung der Korrekturwerte gezeigt.

Um sowohl eine Offset-Korrektur als auch eine Verstärkungskorrektur bestimmen zu können, müssen die Messwerte bei verschiedenen Pegeln des Eingangssignals 3 ermittelt werden. Die Abweichungen der Messwertpaare 21 werden gegen den Eingangspegel des Eingangssignals 3 aufgetragen, wobei die Abweichung eines Messwertpaares 21 durch die Differenz eines korrigierten Messwertes der zweiten Verstärkerschaltung 2 und eines unkorrigierten Messwertes der ersten Verstärkerschaltung 1 gegeben ist. Die Korrekturwerte für den Offsetfehler und den Verstärkungsfehler werden dann dadurch bestimmt, dass zunächst eine Gewichtungsfunktion für das Alter der Messwerte vorgenommen wird, mit der die Messwerte dann beaufschlagt werden. Dann wird für die gegen den Eingangspegel aufgetragenen Differenzen der mit der Gewichtungsfunktion beaufschlagten Messwerte der ersten Verstärkerschaltung 1 und der mit der Gewichtungsfunktion beaufschlagten Messwerte der zweiten Verstärkerschaltung 2 eine Ausgleichsgerade 22 mit dem kleinsten Fehlerquadrat berechnet.

Die Korrektur des Offsetfehlers wird durch den Nulldurchgang 23 der Ausgleichsgeraden 22 und die Korrektur der Verstärkung durch die Steigung 24 der Ausgleichsgeraden 22 bestimmt, wobei die Steigung in Fig. 2 durch ein Steigungsdreieck veranschaulicht ist.

## Patentansprüche

1. Verfahren zur Korrektur von Eingangssignalen eines Messverstärkers, umfassend eine erste analoge Verstärkerschaltung (1), eine zweite analoge Verstärkerschaltung (2), einen der ersten analogen Verstärkerschaltung (1) nachgeschalteten ersten Analog-Digital-Umsetzer (8), einen der zweiten analogen Verstärkerschaltung (2) nachgeschalteten zweiten Analog-Digital-Umsetzer (9) und wenigstens einen Mikroprozessor (10), der mit den beiden Analog-Digital-Umsetzern (8, 9) gekoppelt ist,
wobei die erste analoge Verstärkerschaltung (1) ein Eingangssignal (3) kontinuierlich misst, in Messwerte umwandelt und dem ersten Analog-Digital-Umsetzer (8) zuführt, und
wobei die zweite analoge Verstärkerschaltung (2) das Eingangssignal (3), ein Referenzsignal (5) oder ein Nullsignal (7) misst und dem zweiten Analog-Digital-Umsetzer (9) zuführt,
**dadurch gekennzeichnet, dass**
die durch das Eingangssignal (3) gegebenen Messwerte der zweiten analogen Verstärkerschaltung (2) aufgrund des Referenzsignals (5) und des Nullsignals (7) korrigiert werden, und
der Mikroprozessor (10) aus dem Vergleich der Messwerte der ersten Verstärkerschaltung (1) und der korrigierten Messwerte der zweiten Verstärkerschaltung (2) Korrekturwerte für die Messwerte der ersten Verstärkerschaltung (1) ermittelt.

2. Verfahren nach Anspruch 1, **dadurch gekennzeichnet; dass** das Referenzsignal (5) durch einen Widerstandsteiler erzeugt wird.

3. Verfahren nach Anspruch 1, **dadurch gekennzeichnet, dass** das Referenzsignal (5) durch eine Referenzspannungsquelle erzeugt wird.

4. Verfahren nach einem der Ansprüche 1 bis 3, **dadurch gekennzeichnet, dass** das Nullsignal (7) ein internes Nullsignal ist.

5. Verfahren nach einem der Ansprüche 1 bis 4, **dadurch gekennzeichnet, dass** zur Bestimmung der Korrekturwerte Messwerte des Eingangssignals (3) bei verschiedenen Pegeln des Eingangssignals (3) ausgewählt werden.

6. Verfahren nach Anspruch 5, **dadurch gekennzeichnet, dass** zur Bestimmung der Korrekturwerte der Messwerte des Eingangssignals (3) eine Gewichtungsfunktion herangezogen wird.

7. Verfahren nach Anspruch 6, **dadurch gekennzeichnet, dass** die Gewichtungsfunktion das Alter der Messwerte des Eingangssignals (3) berücksichtigt.

8. Verfahren nach einem der Ansprüche 1 bis 7, **dadurch gekennzeichnet, dass** die Korrekturwerte durch eine Ausgleichsgerade (22) mit kleinstem Fehlerquadrat ermittelt werden, wobei die Steigung (24) der Ausgleichsgeraden (22) zur Bestimmung der Korrekturwerte für die Verstärkung und der Nulldurchgang (23) der Ausgleichsgeraden (22) zur Bestimmung der Korrekturwerte für die Offsetfehler vorgesehen sind.

9. Verfahren nach einem der Ansprüche 1 bis 8, **dadurch gekennzeichnet, dass** die absolute Größe der Signale durch einen Vergleich der Messwerte mit einem externen Kalibriernormal bestimmt wird.

10. Anordnung eines Messverstärkers zur Korrektur von Eingangssignalen, umfassend eine erste analoge Verstärkerschaltung (1), eine zweite analoge Verstärkerschaltung (2), einen der ersten analogen Verstärkerschaltung (1) nachgeschalteten ersten Analog-Digital-Umsetzer (8), einen der zweiten analogen Verstärkerschaltung (2) nachgeschalteten zweiten Analog-Digital-Umsetzer (9) und wenigstens einen Mikroprozessor (10), der mit den beiden Analog-Digital-Umsetzern (8, 9) gekoppelt ist,
wobei die erste analoge Verstärkerschaltung (1) ein Eingangssignal (3) kontinuierlich misst,
wobei Mittel (4, 6) zur Erzeugung eines Referenzsignals (5) und eines Nullsignals (7) vorgesehen sind, und
wobei die zweite analoge Verstärkerschaltung (2) wahlweise das Eingangssignal (3), das Referenzsignal (5) und das Nullsignal (7) misst.

11. Anordnung nach Anspruch 10, **dadurch gekennzeichnet, dass** die beiden Verstärkerschaltungen (1, 2) als Brückenmessverstärker ausgebildet sind.

12. Anordnung nach Anspruch 10, **dadurch gekennzeichnet, dass** die beiden Verstärkerschaltungen (1, 2) als Spannungsverstärker vorgesehen sind.

13. Anordnung nach einem der Ansprüche 10 bis 12, **dadurch gekennzeichnet, dass** die Analog-Digital-Umsetzer (8, 9) als Stereo-Audio-Wandler vorgesehen sind.

14. Anordnung nach einem der Ansprüche 10 bis 13, **dadurch gekennzeichnet, dass** externe Mittel zur Erzeugung eines Kalibriernormals vorgesehen sind.

## Claims

1. Method for correcting input signals of a measuring amplifier, which comprises a first analogue amplifier circuit (1), a second analogue amplifier circuit (2), a first analogue-digital converter (8) downstream-connected to the first analogue amplifier circuit (1), a second analogue-digital converter (9) downstream-connected to the second analogue amplifier circuit (2), and at least one microprocessor (10) interconnected with the two analogue-digital converters (8, 9),
wherein the first analogue amplifier circuit (1) continuously measures an input signal (3), converts it into measured values and transmits them to the first analogue-digital converter (8), and
wherein the second analogue amplifier circuit (2) measures the input signal (3), a reference signal (5) or a zero signal (7) and transmits it to the second analogue-digital converter (9),
**characterized in that**
the measured values of the second analogue amplifier circuit (2), which are given by the input signal (3), are corrected due to the reference signal (5) and the zero signal (7), and
the microprocessor (10) determines correction values for the measured values of the first amplifier circuit (1), based on a comparison of the measured values of the first amplifier circuit (1) and the corrected measured values of the second amplifier circuit (2).

2. Method according to claim 1, **characterized in that** the reference signal (5) is generated by a resistive divider.

3. Method according to claim 1, **characterized in that** the reference signal (5) is generated by a reference voltage source.

4. Method according to any of the claims 1 to 3, **characterized in that** the zero signal (7) is an internal zero signal.

5. Method according to any of the claims 1 to 4, **characterized in that** measured values of input signals (3) with various levels of input signal (3) are selected for determining the correction values.

6. Method according to claim 5, **characterized in that** a weighting function is used for determining the correction values of the measured values of the input signal (3).

7. Method according to claim 6, **characterized in that** the age of the measured values of the input signal (3) is taken into consideration by the weighting function.

8. Method according to any of the claims 1 to 7, **characterized in that** the correction values are ascertained by means of a line of best fit (22) with the smallest square error, the gradient (24) of the line of best fit (22) being destined for determining the correction values for the amplification and the zero-crossing (23) of the line of best fit (22) being destined for determining the correction values for the offset errors.

9. Method according to any of the claims 1 to 8, **characterized in that** the absolute size of the signals is determined by comparing the measured values with an external calibration standard.

10. Arrangement of a measuring amplifier for correcting input signals, which comprises a first analogue amplifier circuit (1), a second analogue amplifier circuit (2), a first analogue-digital converter (8) downstream-connected to the first analogue amplifier circuit (1), a second analogue-digital converter (9) downstream-connected to the second analogue amplifier circuit (2), and at least one microprocessor (10) interconnected with the two analogue-digital converters (8, 9),
wherein the first analogue amplifier circuit (1) continuously measures an input signal (3),
wherein means (4, 6) for generating a reference signal (5) and a zero signal (7) are provided, and
wherein the second analogue amplifier circuit (3) alternatively measures the input signal (3), the reference signal (5) and the zero signal (7).

11. Arrangement according to claim 10, **characterized in that** the two amplifier circuits (1, 2) are developed as bridge-type measuring amplifiers.

12. Arrangement according to claim 10, **characterized in that** the two amplifier circuits (1, 2) are provided as voltage amplifiers.

13. Arrangement according to any of the claims 10 to 12, **characterized in that** the analogue-digital converters (8, 9) are provided as stereo audio converters.

14. Arrangement according to any of the claims 10 to 13, **characterized in that** external means for generating a calibration standard are provided.

## Revendications

1. Procédé de correction de signaux d'entrée d'un amplificateur de mesure, comprenant un premier circuit amplificateur analogique (1), un deuxième circuit amplificateur analogique (2), un premier convertisseur analogique-numérique (8) connecté en aval du premier circuit amplificateur analogique (1), un deuxième convertisseur analogique-numérique (9) connecté en aval du deuxième circuit amplificateur analogique (2), et au moins un microprocesseur (10) qui est relié avec les deux convertisseurs analogique-numérique (8, 9),
dans lequel le premier circuit amplificateur analogique (1) mesure en continu un signal d'entrée (3), convertit en valeurs de mesure et transmet au premier convertisseur analogique-numérique (8), et
dans lequel le deuxième circuit amplificateur analogique (2) mesure le signal d'entrée (3), un signal de référence (5) ou un signal nul (7) et transmet au deuxième convertisseur analogique-numérique (9),
**caractérisé en ce que**
les valeurs de mesure du deuxième circuit amplificateur analogique (2) fournies par le signal d'entrée (3) sont corrigées en raison du signal de référence (5) et du signal nul (7), et
le microprocesseur (10) détermine des valeurs de correction pour les valeurs de mesure du premier circuit amplificateur (1) à partir de la comparaison entre les valeurs de mesure du premier circuit amplificateur (1) et les valeurs de mesure corrigées du deuxième circuit amplificateur (2).

2. Procédé selon la revendication 1, **caractérisé en ce que** le signal de référence (5) est généré par un diviseur résistif.

3. Procédé selon la revendication 1, **caractérisé en ce que** le signal de référence (5) est généré par une source de tension de référence.

4. Procédé selon l'une quelconque des revendications 1 à 3, **caractérisé en ce que** le signal nul (7) est un signal nul interne.

5. Procédé selon l'une quelconque des revendications 1 à 4, **caractérisé en ce que** des valeurs de mesure du signal d'entrée (3) avec différents niveaux de signal d'entrée (3) sont sélectionnées pour déterminer les valeurs de correction.

6. Procédé selon la revendication 5, **caractérisé en ce qu'**une fonction de pondération est utilisée pour déterminer les valeurs de correction des valeurs de mesure du signal d'entrée (3).

7. Procédé selon la revendication 6, **caractérisé en ce que** la fonction de pondération tient compte de l'âge des valeurs de mesure du signal d'entrée (3).

8. Procédé selon l'une quelconque des revendications 1 à 7, **caractérisé en ce que** les valeurs de correction sont déterminées par une droite d'ajustement affine (22) par la méthode des moindres carrés, dans lequel la pente (24) de la droite d'ajustement affine (22) est destinée à la détermination des valeurs de correction pour l'amplification et le passage par zéro (23) de la droite d'ajustement affine (22) est destiné à la détermination des valeurs de correction pour les erreurs de décalage.

9. Procédé selon l'une quelconque des revendications 1 à 8, **caractérisé en ce que** la taille absolue des signaux est déterminée par une comparaison des valeurs de mesure avec un étalon externe de calibration.

10. Arrangement d'un amplificateur de mesure pour la correction de signaux d'entrée, comprenant un premier circuit amplificateur analogique (1), un deuxième circuit amplificateur analogique (2), un premier convertisseur analogique-numérique (8) connecté en aval du premier circuit amplificateur analogique (1), un deuxième convertisseur analogique-numérique (9) connecté en aval du deuxième circuit amplificateur analogique (2), et au moins un microprocesseur (10) qui est relié avec les deux convertisseurs analogique-numérique (8, 9),
dans lequel le premier circuit amplificateur analogique (1) mesure un signal d'entrée (3) de façon continue,
dans lequel des moyens (4, 6) pour générer un signal de référence (5) et un signal nul (7) sont prévus, et
dans lequel le deuxième circuit amplificateur analogique (2) mesure sélectivement le signal d'entrée (3), le signal de référence (5) et le signal nul (7).

11. Arrangement selon la revendication 10, **caractérisé en ce que** les deux circuits amplificateurs (1, 2) sont formés comme des amplificateurs de mesure en pont.

12. Arrangement selon la revendication 10, **caractérisé en ce que** les deux circuits amplificateurs (1, 2) sont prévus comme amplificateurs de tension.

13. Arrangement selon l'une quelconque des revendications 10 à 12, **caractérisé en ce que** les convertisseurs analogique-numérique (8, 9) sont prévus comme convertisseurs audio stéréo.

14. Arrangement selon l'une quelconque des revendications 10 à 13, **caractérisé en ce que** des moyens externes pour générer un étalon de calibration sont prévus.
